# EUROPEAN PATENT APPLICATION

(11) **EP 2 947 382 A1**
(43) Date of publication of application: **25.11.2015**
(21) Application number: 15168678.9
(22) Date of filing: 21.05.2015
(51) Int. Cl.: F21V 3/04, F21K 99/00, F21V 7/00, F21V 7/22, F21Y 101/02

(54) **WAVELENTH CONVERSION MEMBER AND REMOTE PHOSPHOR TYPE LIGHT EMITTING APPARATUS**

(30) Priority: 22.05.2014 JP 2014106312
(71) Applicant: Shin-Etsu Chemical Co., Ltd., Chiyoda-ku Tokyo (JP)
(72) Inventor: Wataya, Kazuhiro, Echizen-shi, Fukui (JP); Tsumori, Toshihiro, Echizen-shi, Fukui (JP); Tsukatan, Toshihiko, Echizen-shi, Fukui (JP)
(74) Representative: Stoner, Gerard Patrick

(57) **Abstract**

A wavelength conversion member including a light emitting member being a molding of a mixture containing a transparent or translucent polymer material and a phosphor, and a reflection layer laminated on part of a surface of the light emitting member. In the wavelength conversion member which converts light from a light source by the phosphor and radiates the converted light in a desired direction, light emitted from the phosphor in the wavelength conversion member which is emitted in other directions than desired radiating direction can be efficiently utilized without loss.

## Description

### TECHNICAL FIELD

The present invention relates to a wavelength conversion member which converts light from a light source by a phosphor and emits the converted light in a desired direction efficiently, and to a remote phosphor type light emitting apparatus in which the wavelength conversion member and a light emitting diode are disposed remote from each other.

### BACKGROUND

Light emitting diodes (LEDs) are among the most efficient light sources currently available. In particular, white LEDs are rapidly expanding in share of the market as the next-generation light source to replace incandescent lamps, fluorescent lamps, cold cathode fluorescent lamp (CCFL) backlights, and halogen lamps. As a configuration for realizing white LEDs, a white LED based on the combination of a blue light emitting diode (blue LED) with a phosphor which, when excited with blue light, emits light of a longer wavelength, for example, yellow light or green light, has been put to practical use. Also, LED illumination using such white LEDs has been put to practical use.

The white LED has a structure in which a phosphor is disposed on or in proximity to a blue LED, in the state of being mixed in a resin or glass, so that part of the blue light is converted into light of a longer wavelength. This system, in which white light is obtained through wavelength conversion by a phosphor layer practically united with the blue LED and which might be called a white LED element, is the mainstream of white LEDs.

Also, there are light emitting apparatuses based on a system in which a phosphor is disposed at a distance of several millimeters to several tens of millimeters from a blue LED so that blue light from the blue LED is partly or wholly wavelength-converted by the phosphor. Especially where the characteristics of the phosphor are liable to be lowered by heat generated from the LED, the remote arrangement of the phosphor from the LED is effective in enhancing the efficiency of the light emitting apparatus and in suppressing variations in tone. A wavelength conversion member including a phosphor and disposed remote from a LED light source in this manner is called a remote phosphor, and such a light emission system is called a remote phosphor system. The remote phosphor type light emission system has the advantage of ensuring an improved overall color uniformity when used for illumination, and has been investigated in recent years.

In the remote phosphor type light emitting apparatuses as above, generally, white light is obtained by a configuration wherein a wavelength conversion member having yellow light emitting phosphor particles, green light emitting phosphor particles and, optionally, red light emitting phosphor particles dispersed in resin or glass is disposed as a remote phosphor in front of a blue LED, for example. Examples of the phosphor used for the remote phosphor include oxide phosphors such as Y₃Al₅O₁₂:Ce, (Y,Gd)₃(Al,Ga)₅O₁₂:Ce, (Y,Gd)₃Al₅O₁₂:Ce, Tb₃Al₅O₁₂:Ce, and (Sr,Ca,Ba)₂SiO₄:Eu, particularly garnet-structured oxide phosphors, silicate phosphors such as β-SiALON:Eu, and red light emitting phosphors. Examples of the red light emitting phosphors include composite fluoride phosphors, and nitride phosphors such as CaAlSiN₃:Eu²⁺ and Sr-CaAlSiN₃:Eu²⁺.

Common light emitting apparatuses are often used for illumination in a specified direction or a specified region. On the other hand, the light emitted from the phosphor contained in the remote phosphor is isotropic; therefore, the light emitted from the remote phosphor has a weakness in that light is emitted also in directions or regions other than the specified direction or region where the light is to be utilized for illumination. In a light emitting apparatus utilizing a remote phosphor, with respect to the light emitted from the light emitting apparatus into other directions or regions than the specified direction or region into which the light is to be radiated, there have been attempts made to improve the radiation efficiency by incorporating a reflection member into the light emitting apparatus. However, there are limitations to the effect of the conventional reflection members. Thus, in practice, of the light emitted from a remote phosphor, the portion emitted in other directions or into regions not being the specified direction or region into which the light is to be radiated is mostly lost without being used.

In an illuminator, the proportions, the manners of spreading, and the chromaticities of the portions of light emitted toward the front side, lateral side and rear side of the illuminator are important factors in designing an illuminated space. Light emitting devices enabling a design to be made taking into account the light quantity distribution and chromaticity distribution in respective directions, so as to meet the design-basis demand of a space to be illuminated, are not common; thus, there are restrictions on designing an illuminated space.

### Citation List

Patent Document 1: JP-A 2011-256371

### THE INVENTION

It would be desirable, therefore, to provide a wavelength conversion member which converts light from a light source by a phosphor and efficiently emits the converted light in a desired direction, particularly a wavelength conversion member suitable for use in a remote phosphor type light emitting apparatus, and a remote phosphor type light emitting apparatus which can efficiently utilize light emitted in other directions than the intended radiating direction among light emitted from a phosphor of a wavelength conversion member, avoiding loss. Further, it is desired to provide a wavelength conversion member which has high degrees of freedom in luminous intensity distribution and chromaticity regarding an arbitrary direction, and a remote phosphor type light emitting apparatus which offers a high degree of freedom in designing an illuminated space.

The present inventors made studies of a wavelength conversion member containing a phosphor which absorbs light having a predetermined wavelength, converts the wavelength of the light and emits the resulting light having a converted wavelength, and a remote phosphor type light emitting apparatus using such a wavelength conversion member. As a result of the studies, it was found that, in the wavelength conversion member containing a phosphor, when excitation light is radiated onto the phosphor, the wavelength-converted light is emitted from the wavelength conversion member in an isotropic manner, toward the excitation light incidence side, the opposite side and the lateral sides, and part of the excitation light is transmitted through the wavelength conversion member. In a light emitting device using such a wavelength conversion member, most of the light emitted in directions other than the desired radiating direction from the light emitting apparatus is low in the rate of contribution to the intended radiation of light and is therefore wasted as the optical energy. Paying attention to these points, the present inventors considered that if the optical energy which would thus be wasted can be utilized efficiently, a light emitting apparatus having an enhanced illuminance can be realized.

On the basis of the consideration, the present inventors made extensive and intensive investigations for meeting the above-mentioned needs. As a result, the inventors found that where a light emitting member is formed by molding a mixture containing a transparent or translucent polymer material and a phosphor and when a reflection layer for reflecting light, emitted from the phosphor, toward the light emitting member side is laminated on part of a surface of the light emitting member to obtain a wavelength conversion member (and, particularly, when the wavelength conversion member is used in a remote phosphor type light emitting apparatus), the light emitted from the phosphor in the wavelength conversion member which would otherwise travel in directions other than a desired light radiating direction can be guided into the desired light radiating direction, whereby the illuminance in the desired light radiating direction can be enhanced effectively. Furthermore, it was also found that when the reflection layer is laminated only on a specified portion of the surface of the light emitting member, light can be radiated from the light emitting apparatus not only toward the forward side but also widely toward the rear and lateral sides, with control of illuminance and chromaticity, that the space to be illuminated can be illuminated variously through control of illuminance and chromaticity on the basis of each light radiating direction, and that a novel light emitting apparatus which was unavailable in prior art can be provided. Based on the findings, the present invention has been accomplished.

Therefore, the present invention provides a wavelength conversion member and a remote phosphor type light emitting apparatus as follows.

In one aspect, the invention provides a wavelength conversion member including a light emitting member being a molded object of a mixture comprising a transparent or translucent polymer material and a phosphor, and a reflection layer laminated on part of a surface of the light emitting member. The reflection layer is adapted to reflect light emitted from the phosphor toward the light emitting member side.

In preferred embodiments, the wavelength conversion member includes at least two layers in which different phosphors are mixed each other.

Preferably, the reflection layer has a mirror surface on the light emitting member side.

Also preferably, the polymer material is at least one resin selected from thermoplastic resins and thermosetting resins.

Also preferably, the phosphor absorbs light having a wavelength of up to 470 nm and emits visible light.

Preferably, based on one direction of light emission from the light emitting member being a forward direction, the reflection layer is laminated on part or whole of a rearward-side surface of the light emitting member and/or on part or whole of a lateral-side surface of the light emitting member.

In another aspect, the invention provides a remote phosphor type light emitting apparatus including a wavelength conversion member of the first aspect, and a light emitting diode, wherein the wavelength conversion member and the light emitting diode are disposed remote from each other with a gas layer or a vacuum layer intervening therebetween, and light from the light emitting diode enters into the wavelength conversion member through a surface on which the reflection layer is not laminated.

Preferably the phosphor is a phosphor which absorbs light having a wavelength of up to 470 nm and emits visible light. Preferably, the light emitting diode emits light having a wavelength of up to 470 nm.

Preferably, based on a light radiating direction of the light emitting apparatus being a forward direction, the reflection layer is laminated on part or whole of a rearward-side surface of the light emitting member and/or on part or whole of a lateral-side surface of the light emitting member.

### ADVANTAGEOUS EFFECTS OF THE INVENTION

In the wavelength conversion member which converts light from a light source by the phosphor and radiates the converted light in a desired direction, light emitted from the phosphor in the wavelength conversion member which is emitted in directions other than the desired radiating direction can be efficiently utilized, avoiding loss. In addition, when this wavelength conversion member is applied to a remote phosphor type light emitting apparatus, light emitted from the phosphor in the wavelength conversion member which would otherwise travel in other directions than the desired radiating direction of the light emitting apparatus can be guided into the desired radiating direction, whereby the illuminance in the desired radiating direction can be enhanced effectively.

Besides, it is possible to provide a wavelength conversion member and a remote phosphor type light emitting apparatus which are high in the degrees of freedom in luminous intensity distribution and chromaticity regarding an arbitrary direction and which offer a high degree of freedom in designing an illuminated space.

### BRIEF DESCRIPTION OF THE DRAWINGS

FIGS. 1A and 1B show a perspective view and a sectional view, respectively, of an example for a first embodiment of a remote phosphor type light emitting apparatus of the present invention having a wavelength conversion member.
FIG. 2 shows a sectional view of an example for a second embodiment of a remote phosphor type light emitting apparatus of the present invention having a wavelength conversion member.
FIGS. 3A and 3B show a plan view and a sectional view, respectively, of an example for a third embodiment of a remote phosphor type light emitting apparatus of the present invention having a wavelength conversion member.
FIGS. 4A and 4B show a plan view and a sectional view, respectively, of an example for a fourth embodiment of a remote phosphor type light emitting apparatus of the present invention having a wavelength conversion member.

### FURTHER EXPLANATIONS; OPTIONS AND PREFERENCES

The wavelength conversion member according to the present invention will be described and explained in detail below.

A wavelength conversion member according to the present invention includes a light emitting member (a light emitting section) which is a molded article of a mixture containing a polymer material and a phosphor, and a reflection layer laminated on part of a surface of the light emitting member. The wavelength conversion member according to the present invention is sometimes referred to as a remote phosphor, in the case of being used in a remote phosphor type light emitting apparatus.

As the polymer material, transparent or translucent ones may be used, of which the transparent ones are particularly preferred. Rubbers, elastomers and resins can be used as the polymer material, but in general preferably at least one resin selected from thermoplastic resins and thermosetting resins is used. Examples of the thermoplastic resins include polyethylene, polypropylene, polyvinyl chloride, polystyrene, polyvinyl acetate, fluoro-resins, Teflon (registered trademark), ABS resins, AS resins, acrylic resins, polyamides, polyacetal, polycarbonate, modified polyphenylene ethers, polybutylene terephthalate, polyethylene terephthalate, cyclic polyolefins, polyphenylene sulfide, polysulfones and thermoplastic polyimides. On the other hand, examples of the thermosetting resins include amino resins, phenol resins, epoxy resins, melamine resins, urea resins, unsaturated polyester resins, alkyd resins, polyurethane and thermosetting polyimides.

The phosphor is a phosphor which absorbs light having a predetermined wavelength, converting the wavelength of the light by emitting a resulting light having a converted wavelength. The phosphor can be prepared by a known method, or can be used as a commercially available one. The phosphor may be used in a granular or powdery form. As for the particle diameter of the phosphor, the particle diameter D50 corresponding to a cumulative volume of 50% in the particle size distribution is preferably at least 1.0 µm, particularly at least 1.5 µm and is preferably up to 100 µm, particularly up to 40 µm. Furthermore, the particle diameter D90 corresponding to a cumulative volume of 90% is preferably up to 200 µm, particularly up to 100 µm. Note that as the particle diameter of the phosphor referred to herein, there can be applied, for example, a particle diameter value obtained by dispersing a phosphor in a gas stream or water stream and measuring the particle diameter of the phosphor by a laser diffraction scattering method.

As the phosphor, a single phosphor may be used, or a plurality of phosphors may be used in a mixed state. Besides, in the present invention, the light emitting member may be configured to include at least two layers in which different phosphors are mixed. In that case, a single phosphor may be used in each of the at least two layers, or a plurality of phosphors may be used in a mixed state in each of the at least two layers.

Preferably, the phosphor absorbs blue light having a wavelength of up to 470 nm, particularly a wavelength of 400 nm to 470 nm, and emits visible light. Examples of such a phosphor include oxide phosphors such as Y₃Al₅O₁₂:Ce, (Y,Gd)₃(Al,Ga)₅O₁₂:Ce, (Y,Gd)₃Al₅O₁₂:Ce, Tb₃Al₅O₁₂:Ce, and (Sr,Ca,Ba)₂SiO₄:Eu, particularly garnet-structured oxide phosphors, silicate phosphors such as β-SiAlON:Eu, and red light emitting phosphors. Examples of the red light emitting phosphors include composite fluoride phosphors and nitride phosphors such as CaAlSiN₃:Eu2+ and Sr-CaAlSiN₃:Eu²⁺.

In addition to the polymer material and the phosphor, the light emitting member may contain an additive or additives in such ranges as not to be detrimental to the object of the present invention or to the intended function of the wavelength conversion member. Examples of the additives include a light scattering agent for accelerating the scattering of light. The content of the additive or additives in the light emitting member is ordinarily up to 10 wt%, particularly in the range of 0.01 wt% to 5 wt%, based on the weight of the light emitting member.

The content of the phosphor in the light emitting member is preferably 0.1 wt% to 50 wt%, the balance being the content of the polymer material in the case where no additive is used in the light emitting member in addition to the polymer material and the phosphor, and the balance being the total content of the polymer material and an additive or additives in the case where the additive or additives are used in the light emitting member in addition to the polymer material and the phosphor.

The light emitting member can be obtained by mixing the polymer material, the phosphor and, optionally, the additive or additives and molding the resulting mixture. To the molding, there can be applied a known molding method such as compression molding, extrusion molding, or injection molding, whereby the mixture may be molded into any desired shape such as a film or sheet form and in a desired size.

The shape and size of the light emitting member may be appropriately selected according to the intended use of the wavelength conversion member. It is to be noted, however, that the shape and size should be so selected that the reflection layer as described later can be formed. Particularly, in consideration of the use of the wavelength conversion member in combination with a light emitting diode or diodes as a light emitting apparatus, it is desirable for the light emitting member to have a thickness such that upon formation of the wavelength conversion member using the light emitting member, the wavelength conversion member can maintain a fixed shape by itself. Such a thickness of the light emitting member is not particularly limited, and is ordinarily in the range of 0.1 mm to 6 mm.

On part of a surface of the light emitting member, there is laminated a reflection layer by which light emitted from the phosphor is reflected toward the light emitting member side. In the wavelength conversion member according to the present invention, the surface of the light emitting member includes an area where reflection layer is not laminated. Excitation light for the phosphor is able to enter the light emitting member through part or whole of the area where the reflection layer is not laminated. Also, light emitted from the phosphor is radiated to the outside of the wavelength conversion member though part or whole of the area where the reflection layer is not laminated.

In the wavelength conversion member, taking an arbitrary direction of light emission from the light emitting member as being a forward direction, the reflection layer is preferably provided on part or whole of a rearward-side surface of the light emitting member. In this case, when the reflection layer is provided on the whole of the rearward-side surface, emission of light toward the rear side of the wavelength conversion member can be blocked. When the reflection layer is provided on part of the rearward-side surface (when part of the rearward-side surface is left as an area where the reflection layer is not laminated), light can be emitted also toward the rear side of the wavelength conversion member. Note that the aforementioned one arbitrary direction of light emission from the light emitting member ordinarily corresponds to the side of incidence of the excitation light.

In the wavelength conversion member according to the present invention, based on the aforementioned one arbitrary direction of light emission from the light emitting member being a forward direction, the reflection layer is preferably provided on part or whole of a lateral-side surface of the light emitting member. In this case, when the reflection layer is provided on whole of the lateral-side surface, emission of light toward the lateral side of the wavelength conversion member can be blocked. When the reflection layer is provided on part of the lateral-side surface (when part of the lateral-side surface is left as an area where the reflection layer is not laminated), light can be emitted also toward the lateral side of the wavelength conversion member.

The thickness of the wavelength conversion member may be the total thickness of the light emitting member and the reflection layer. In the case where the reflection layer is provided only on the rearward-side surface of the light emitting member mentioned above, the thickness of the wavelength conversion member is the sum of the thickness of the light emitting member mentioned above and the thickness of the reflection layer mentioned above. In the wavelength conversion member according to the present invention, the reflection layer may be provided also on part of the surface on the side of the aforementioned one arbitrary direction of the light emitting member. In that case, the thickness of the wavelength conversion member is the sum of the thickness of the light emitting member mentioned above and twice the thickness of the reflection layer mentioned above.

It is sufficient for the reflection layer to be formed from a material by which the light emitted from the phosphor can be reflected toward the light emitting member side, further preferably, a material by which the excitation light can be reflected toward the light emitting member side. Especially, it is preferable that a surface, on the light emitting member side, of the reflection layer is a mirror surface. In order that the surface, on the light emitting member side, of the reflection layer is made to be a mirror surface, there may be applied a known mirror surface forming method such as an electroless plating method (e.g. silver mirror reaction), a metal vapor deposition method and a reflective film material applying method. That surface of the light emitting member on which to form the reflection layer may be coated with a silicone resin (e.g. an acryl-modified silicone resin) used as an adhesion enhancing material, in order to enhance the adhesion of the reflection layer. In carrying out the coating, a solution of the silicone resin may be applied. If the surface region where the reflection layer is not to be formed is masked, e.g. with a masking tape, the reflection layer can be formed only on the desired surface portion. In addition, after the reflection layer is once formed, a desired portion of the reflection layer can be removed by etching or polishing. In addition, in the wavelength conversion member according to the present invention, a protective layer may further be provided on the reflection layer.

The silver mirror reaction as the method of forming the reflection layer on the light emitting member is used preferably, since it enables a mirror surface to be easily formed at a surface of a light emitting member which is complicated in shape. In the case of applying the silver mirror reaction, for example, a mixed aqueous solution of an ammoniacal aqueous silver nitrate solution, an aqueous sodium hydroxide solution and an aqueous glucose solution is brought into contact with the light emitting member, whereby a silver mirror having a mirror surface on the light emitting member side can be formed on the surface of the light emitting member.

The remote phosphor type light emitting apparatus according to the present invention will be described in detail below.

The remote phosphor type light emitting apparatus according to the present invention includes a wavelength conversion member containing a phosphor which absorbs light having a predetermined wavelength, converts the wavelength of the light and emits the resulting light having a converted wavelength, and a light emitting diode, wherein the wavelength conversion member and the light emitting diode are disposed remote from each other with a gas layer intervening therebetween. In the remote phosphor type light emitting apparatus, the wavelength conversion member and the light emitting diode are so disposed that excitation light emitted from the light emitting diode is incident on the wavelength conversion member.

In the remote phosphor type light emitting device according to the present invention, there is preferably used the aforementioned wavelength conversion member which includes a light emitting member which is a molded object of a mixture containing a polymer material and a phosphor, and a reflection layer laminated on part of a surface of the light emitting member. The wavelength conversion member and the light emitting diode are so arranged that the light from the light emitting diode enters the wavelength conversion member through a surface on which the reflection layer is not laminated, of the wavelength conversion member.

The light emitting diode for emitting the excitation light may be appropriately selected according to an absorption wavelength of the phosphor. In the case where a phosphor which emits light upon absorbing light having a wavelength of up to 470 nm is used in the wavelength conversion member, it is preferable to use a light emitting diode which emits light having a center wavelength of up to 470 nm, particularly a blue light emitting diode which emits blue light having a center wavelength of 440 nm to 470 nm.

As for configurations and features of the remote phosphor type light emitting apparatus other than the wavelength conversion member and the light emitting diode, configurations of remote phosphor type light emitting apparatuses which have been known can be applied.

In the remote phosphor type light emitting apparatus according to the present invention, based on the light radiating direction of the light emitting apparatus being a forward direction, the reflection layer is preferably provided on part or whole of a rearward-side surface of the light emitting member of the wavelength conversion member. In this case, when the reflection layer is provided on whole of the rearward-side surface, emission of light toward the rear side of the light emitting apparatus can be blocked. When the reflection layer is provided on part of the rearward-side surface (when part of the rearward-side surface is left as an area where the reflection layer is not laminated), on the other hand, light can be radiated also toward the rear side of the light emitting apparatus. Note that the light radiating direction of the light emitting apparatus ordinarily corresponds to the side of incidence of the excitation light. Such surface region of the member without reflection layer can provide both light entry region and light emitting region.

In the remote phosphor type light emitting apparatus according to the present invention, based on the light radiating direction of the light emitting apparatus being a forward direction, the reflection layer is preferably provided on part or whole of a lateral-side surface of the light emitting member of the wavelength conversion member. In this case, when the reflection layer is provided on whole of the lateral-side surface, emission of light toward the lateral side of the light emitting apparatus can be blocked. When the reflection layer is provided on part of the lateral-side surface (when part of the lateral-side surface is left as an area where the reflection layer is not laminated), on the other hand, light can be radiated also toward the lateral side of the light emitting apparatus.

In the wavelength conversion member of the remote phosphor type light emitting apparatus according to the present invention, the reflection layer can be provided also on part of a surface on the light radiating direction side, of the light emitting apparatus.

The remote phosphor type light emitting apparatus according to the present invention will be described further in detail below, referring to specific examples.

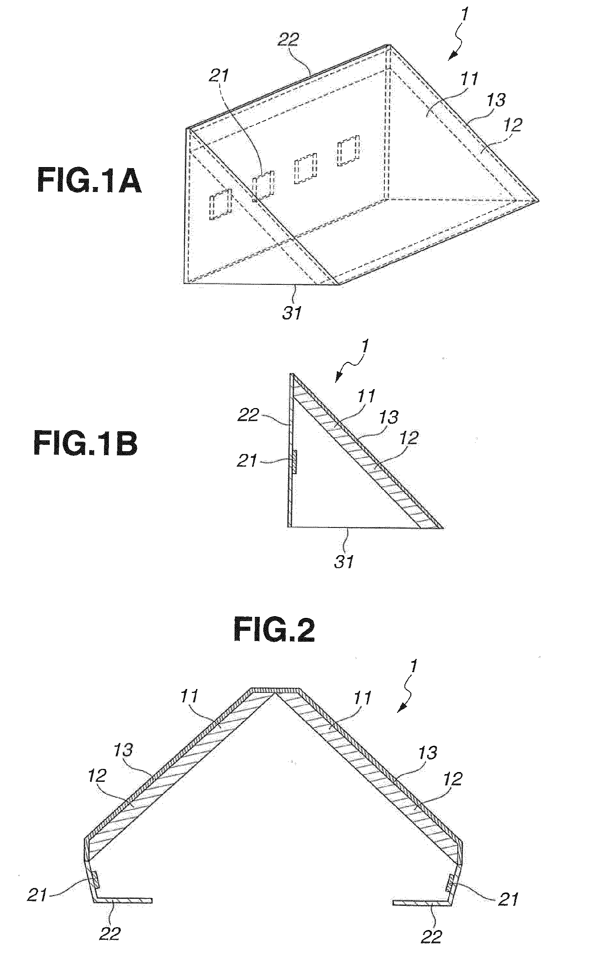

FIGS. 1A and 1B show a first embodiment of carrying out the present invention which corresponds to an example of the remote phosphor type light emitting apparatus having the wavelength conversion member according to the present invention. This remote phosphor type light emitting apparatus 1 has a triangular prismatic overall shape with a right-angled triangular base. A wavelength conversion member 11 having a light emitting member 12 and a reflection layer 13 is disposed at a slant surface portion of the triangular prismatic shape, an opaque substrate 22 is disposed at each of a vertical surface portion and end face portions of the triangular prismatic shape, and a transparent cover 31 is disposed at a bottom surface portion of the triangular prismatic shape. Four light emitting diodes 21 are mounted onto the substrate 22 at the vertical surface portion of the triangular prismatic shape, with their light emitting surfaces directed toward the wavelength conversion member 11. The wavelength conversion member 11 is disposed with its light emitting member 12 oriented inward, and the reflection layer 13 is laminated only on the outside surface (the surface on the rearward side with respect to the light radiating direction) of the light emitting member 12.

In the case of this remote phosphor type light emitting apparatus 1, excitation light emitted from the light emitting diodes 21 reaches the light emitting member 12 of the wavelength conversion member 11, in which wavelength conversion is performed by a phosphor contained in the light emitting member 12, and the resulting light having a converted wavelength is emitted isotropically. Of the converted-wavelength light, a portion proceeds toward the transparent cover 31 side (in the light radiating direction), while another portion travels toward the reflection layer 13 side. The portion of light going toward the reflection layer 13 side is reflected by the reflection layer 13, to be guided toward the transparent cover 31 side. Then, both of the portions of light are united, before being radiated in the light radiating direction at a high illuminance.

FIG. 2 shows a second embodiment of carrying out the present invention which corresponds to an example of the remote phosphor type light emitting apparatus having the wavelength conversion member according to the present invention. This remote phosphor type light emitting apparatus 1 has an umbrella-like overall shape. A wavelength conversion member 11 having a light emitting member 12 and a reflection layer 13 is disposed at an upper, inclined surface portion of the umbrella-like shape, and a transparent substrate 22 roughly L-shaped in cross section is disposed at a lower portion of the umbrella-like shape. Light emitting diodes 21 (only two of them are shown in FIG. 2) are mounted onto the substrate 22 at the lower portion of the umbrella-like shape, with their light emitting surfaces oriented toward the wavelength conversion member 11. The wavelength conversion member 11 is disposed with its light emitting member 12 oriented inward, and the reflection layer 13 is laminated only on outside surfaces (a surface on the rearward side and a surface on the lateral side, with respect to the light radiating direction).

In the case of this remote phosphor type light emitting apparatus 1, excitation light emitted from the light emitting diodes 21 reaches the light emitting member 12 of the wavelength conversion member 11, in which wavelength conversion is conducted by a phosphor contained in the light emitting member 12, and the resulting light having a converted wavelength is emitted isotropically. Of the converted-wavelength light, a portion proceeds toward a lower, opening side (in a light radiating direction), while another portion travels toward the reflection layer 13 side. The portion of light going toward the reflection layer 13 side is reflected by the reflection layer 13, to be guided toward the opening side. Then, both portions of light are united before being radiated in the light radiating direction at a high illuminance.

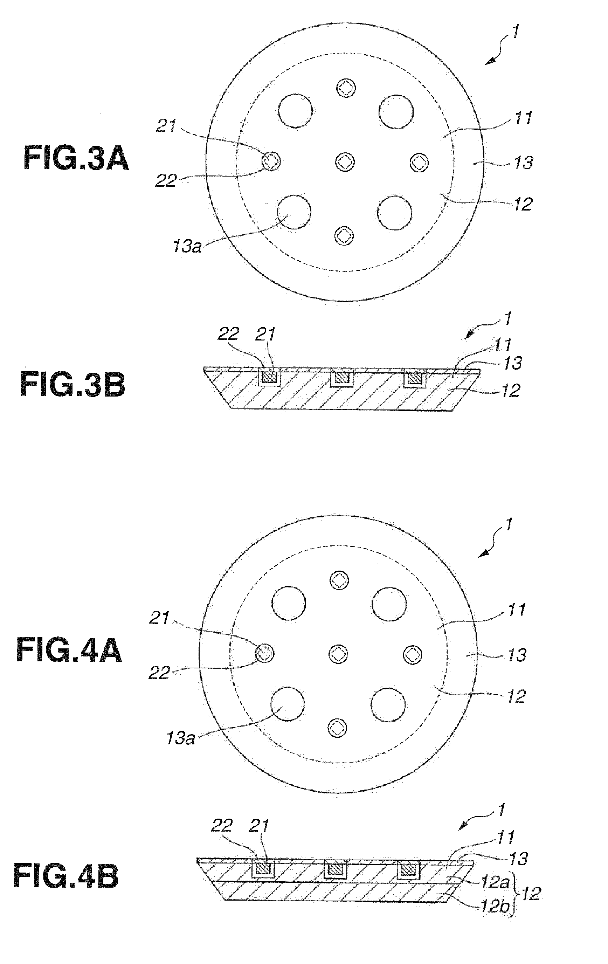

FIGS. 3A and 3B and FIGS. 4A and 4B show a third embodiment and a fourth embodiment for carrying out the present invention which each correspond to an example of the remote phosphor type light emitting apparatus having the wavelength conversion member according to the present invention. These remote phosphor type light emitting apparatuses 1 have a disc-like overall shape, with an inverted trapezoidal cross-sectional shape. A wavelength conversion member 11 has a light emitting member 12 and a reflection layer 13. An upper portion of the wavelength conversion member 11 has depressions in five positions. Five light emitting diodes 21 each mounted onto an opaque substrate 22 are mounted in the depressions, with their light emitting surfaces oriented toward the wavelength conversion member 11. The reflection layer 13 of the wavelength conversion member 11 is laminated only on that surface of the light emitting member 12 which is on the upper side (on the side where the light emitting diodes 21 are embedded). In four positions within the area of the reflection layer 13, reflection-layer-free areas 13a are provided. In the third embodiment shown in FIGS. 3A and 3B, the light emitting member 12 is formed by providing a single layer. In the fourth embodiment shown in FIGS. 4A and 4B, the light emitting member 12 is formed by providing two layers, namely, a first layer 12a and a second layer 12b.

In the cases of these remote phosphor type light emitting apparatuses 1, excitation light emitted from the light emitting diodes 21 reaches the light emitting member 12 (the first layer 12a and the second layer 12b) of the wavelength conversion member 11, in which wavelength conversion is performed by a phosphor contained in the light emitting member 12 (the first layer 12a and the second layer 12b), and the resulting light having a converted wavelength is emitted isotropically. Of the converted-wavelength light, a portion proceeds toward lower and lateral sides (in a main light radiating direction), while another portion travels toward an upper side. The light going toward the reflection layer 13 side is reflected by the reflection layer 13, to be guided toward the lower side and lateral sides. Then, both the portions of light are united, before being radiated in the main light radiating direction at a high illuminance. In addition, a portion of the light going toward the upper side is radiated toward the upper side (in a sub or secondary light radiating direction) by passing through the areas 13a where the reflection layer is not laminated.

In the cases of these remote phosphor type light emitting devices 1, by adjusting the proportion and positions of the regions 13a where reflection layer is not laminated, it is possible to radiate light not only toward the lower and lateral sides (in the main light radiating direction) but also toward the upper side (in the subsidiary light radiating direction). Accordingly, light can be radiated while controlling the illuminance, contrast and radiating direction, in both of the main light radiating direction and the sub light radiating direction. Also, in the case of the remote phosphor type light emitting apparatus 1 in the fourth embodiment as illustrated in FIGS. 4A and 4B, by using different phosphors respectively in the first layer 12a and the second layer 12b, it is possible to change the color of emitted light and the chromaticity in both of the main and sub light radiating directions.

### EXAMPLES

The present invention will be described specifically below, referring to Examples and Comparative Examples, however the present invention is not to be limited to the following Examples.

### Example 1

9,800 g of non-modified polypropylene having a specific gravity of 0.91, 200 g of a YAG:Ce³⁺ phosphor having an average particle diameter of 18.0 µm, and 100 g of silica powder having an average particle diameter of 5.5 µm were mixed in a kneader, to obtain phosphor-containing resin pellets 1. In addition, 9,000 g of non-modified polypropylene having a specific gravity of 0.91 and 1,000 g of a KSF phosphor (K₂SiF₆:Mn) having a particle diameter of 21.0 µm were mixed in a kneader, to obtain phosphor-containing pellets 2.

The phosphor-containing pellets 1 and the phosphor-containing pellets 2 were subjected to two-color extrusion, with care taken so that air would not enter into the interface between layers, followed by press molding for molding into a hemispherical cap-like shape having a thickness of 2 mm and a diameter of 300 mm, to obtain a light emitting member consisting of two layers. The light emitting member thus obtained included the YAG:Ce³⁺ phosphor in an outer layer and the KSF phosphor in an inner layer, respectively, in the hemispherical cap-like shape.

Next, a masking tape was adhered only to the whole area of an inner hemispherical surface of the hemispherical cap-shaped light emitting member, and the light emitting member masked with the masking tape was immersed in a solution of an acryl-modified silicone resin in an organic solvent. In this manner, the portions of the light emitting member onto which the masking tape was not adhered (the outer hemispherical surface and a circular ring-shaped bottom surface of the hemispherical cap-shaped light emitting member) were coated with the acryl-modified silicone resin used as an adhesion enhancing material.

Subsequently, an ammoniacal aqueous silver nitrate solution containing an excess of ammonia and having a silver nitrate concentration of 35 g/L, an aqueous sodium hydroxide solution having a concentration of 20 g/L, and an aqueous glucose solution having a concentration of 15 g/L were prepared in an amount of 1 L each. The three kinds of aqueous solutions were mixed together to prepare a solution for silver mirror reaction. The light emitting member having been masked with the masking tape and coated with the adhesion enhancing material was immersed in the solution for silver mirror reaction, whereon a uniform silver mirror film was formed by a silver mirror reaction on the outer hemispherical surface and the circular ring-shaped bottom surface of the light emitting member. The silver mirror film thus obtained was subjected to a copper plating treatment, known in the mirror manufacturing industry, followed by application of a backing paint. Then, the masking tape was peeled off, followed by drying at 30°C for 24 hours, to obtain a wavelength conversion member having a reflection layer.

When the wavelength conversion member was irradiated with light emitted by a blue LED having a center wavelength of 460 nm, from the inner hemispherical surface side of the wavelength conversion member, strong white light was obtained only from the inner hemispherical surface of the wavelength conversion member.

Next, using the wavelength conversion member and light emitting diodes, a remote phosphor type light emitting device was fabricated. Five blue LEDs (output: 2 W) having a center wavelength of 450 nm to 465 nm were arranged radially on a transparent resin plate, to obtain a light source. In the manner of covering the light source, the hemispherical cap-shaped wavelength conversion member was disposed so that the center axis of the wavelength conversion member coincided with the center of the light source and that blue light emitted from the light source was radiated to the whole of the inner hemispherical surface of the wavelength conversion member.

When the blue LEDs of the light emitting apparatus were turned on, white light was observed coming only from the inner hemispherical surface of the wavelength conversion member. For this light emitting apparatus, the illuminance at a distance of 2.5 m downward from the upper end of the inner hemispherical surface of the wavelength conversion member was measured to be about 550 lx.

### Comparative Example 1

The steps up to the press molding were conducted in the same manner as in Example 1, whereby only a light emitting member not provided with a reflection layer was produced. Light emitted from blue LEDs having a wavelength of 460 nm was radiated to the light emitting member from the inner hemispherical surface side thereof. Although white light was obtained, the white light was observed coming not only from the inner hemispherical surface of the light emitting member but also from the outer hemispherical surface and the circular ring-shaped bottom surface. In addition, the emission of light from the inner hemispherical surface of the light emitting member was weaker than in Example 1.

Using this light emitting member, a light emitting apparatus was fabricated in the same manner as in Example 1. When the blue LEDs were turned on, white light was observed coming evenly from the inner hemispherical surface, the outer hemispherical surface and the circular ring-shaped bottom surface of the light emitting member. For this light emitting apparatus, the illuminance at a distance of 2.5 m downward from the upper end of the inner hemispherical surface of the light emitting member was measured to be about 380 lx.

### Example 2

The steps up to the press molding were carried out in the same manner as in Example 1. Then, the inner hemispherical surface of the hemispherical cap-shaped light emitting member was entirely masked with a masking tape, whereas the outer hemispherical surface was masked in a grid pattern with the masking tape. Besides, as in Example 1, the portions of the light emitting member which were not masked with the masking tape (part of the outer hemispherical surface and the circular ring-shaped bottom surface of the hemispherical cap-shaped light emitting member) were coated with an acryl-modified silicone resin, and the silver mirror film was formed by a silver mirror reaction as in Example 1 to obtain a wavelength conversion member having a reflection layer.

Light emitted from blue LEDs having a center wavelength of 460 nm was radiated to the wavelength conversion member from the inner hemispherical surface side thereof. As a result, white light was obtained as coming from both the inner hemispherical surface and the outer hemispherical surface of the wavelength conversion member. For the white light thus obtained, the chromaticity was measured. The white light coming from the inner hemispherical surface had an x value of 0.3533 and a y value of 0.3537, in the x,y chromaticity coordinates. The white light coming from the outer hemispherical surface had an x value of 0.3752 and a y value of 0.3501. Thus, the white light on the outer side was a warmer color as compared with the white light on the inner side.

Next, using this wavelength conversion member and light emitting diodes, a remote phosphor type light emitting apparatus was fabricated in the same manner as in Example 1.

When the blue LEDs of the light emitting apparatus were turned on, white light was observed coming from the inner hemispherical surface of the wavelength conversion member. For this light emitting apparatus, the illuminance at a distance of 2.5 m downward from the upper end of the inner hemispherical surface of the wavelength conversion member was measured to be about 430 lx. Besides, in this light emitting apparatus, part of the outer hemispherical surface of the wavelength conversion member was not provided thereon with the reflection layer. Therefore, white light was observed coming also from the outer hemispherical surface.

Thus, by changing the kind of the phosphor in the light emitting layer or the layer configuration thereof, and/or changing the portion where the reflection layer is formed, the area, or shape thereof, it is possible to appropriately set the illuminance and chromaticity with respect to each light radiating direction.

### Notes

In respect of numerical ranges disclosed in the present description it will of course be understood that in the normal way the technical criterion for the upper limit is different from the technical criterion for the lower limit, i.e. the upper and lower limits are intrinsically distinct proposals.

For the avoidance of doubt it is confirmed that in the general description above, in the usual way the proposal of general preferences and options in respect of different features of the wavelength conversion member and light emitting device or apparatus constitutes the proposal of general combinations of those general preferences and options for the different features, insofar as they are combinable and compatible and are put forward in the same context.

## Claims

1. A wavelength conversion member comprising
a light emitting member, being a molded object of a mixture comprising a transparent or translucent polymer material and a phosphor, and
a reflection layer laminated on part of the surface of the light emitting member, the reflection layer being adapted to reflect light emitted from the phosphor into the light emitting member side.

2. A wavelength conversion member of claim 1, wherein the light emitting member comprises at least two layers, in which different respective phosphors are mixed.

3. A wavelength conversion member of claim 1 or 2, wherein the reflection layer has a mirror surface on the light emitting member side.

4. A wavelength conversion member of claim 3 wherein the reflection layer is a silver mirror layer.

5. A wavelength conversion member of any one of claims 1 to 4, wherein the polymer material is at least one resin.

6. A wavelength conversion member of any one of claims 1 to 5 wherein the light emitting member is in film or sheet form having a thickness from 0.1 to 6 mm.

7. A wavelength conversion member of any one of claims 1 to 6, wherein the phosphor absorbs light having a wavelength of up to 470 nm and emits visible light.

8. A wavelength conversion member of any one of claims 1 to 7 wherein, based on one direction of light emission from the light emitting member being a forward direction, the reflection layer is laminated on part or whole of a rearward-side surface of the light emitting member.

9. The wavelength conversion member of any one of claims 1 to 8 wherein, based on one direction of light emission from the light emitting member being a forward direction, the reflection layer is laminated on part or whole of a lateral-side surface of the light emitting member.

10. A remote phosphor type light emitting apparatus comprising
a wavelength conversion member any one of claims 1 to 6, and
a light emitting diode,
wherein the wavelength conversion member and the light emitting diode are disposed remote from each other with a gas layer or a vacuum layer intervening therebetween, and light from the light emitting diode enters the wavelength conversion member through a surface on which the reflection layer is not laminated.

11. A remote phosphor type light emitting apparatus of claim 10 wherein the phosphor absorbs light having a wavelength of up to 470 nm and emits visible light.

12. A remote phosphor type light emitting apparatus of claim 11 wherein the light emitting diode emits light having a wavelength of up to 470 nm.

13. A remote phosphor type light emitting apparatus of any one of claims 10 to 12 wherein, based on a light radiating direction of the light emitting apparatus being a forward direction, the reflection layer is laminated on part or whole of a rearward-side surface of the light emitting member.

14. A remote phosphor type light emitting apparatus of any one of claims 10 to 13 wherein, based on a light radiating direction of the light emitting apparatus being a forward direction, the reflection layer is laminated on part or whole of a lateral-side surface of the light emitting member.
